# EUROPÄISCHE PATENTSCHRIFT

(11) **EP 0 435 371 B1**
(45) Veröffentlichungstag und Bekanntmachung des Hinweises auf die Patenterteilung: **30.08.1995**
(21) Anmeldenummer: 90203315.8
(22) Anmeldetag: 13.12.1990
(51) Int. Cl.: G01R 31/02, G01R 19/165, G05F 1/585

(54) **Stromversorgungseinrichtung mit Unsymmetrieüberwachungsschaltung**
Power supply device with non-symmetric monitoring
Source d'alimentation avec circuit détecteur dissymétrique

(30) Priorität: 19.12.1989 DE 3941885
(43) Veröffentlichungstag der Anmeldung: 03.07.1991
(73) Patentinhaber: Philips Patentverwaltung GmbH, 22335 Hamburg (DE); Philips Electronics N.V., 5621 BA Eindhoven (NL)
(72) Erfinder: Frühling, Gerhard, Dipl.-Ing., W-8500 Nürnberg 10 (DE)
(74) Vertreter: Peuckert, Hermann, Dipl.-Ing.

(56) Entgegenhaltungen:
- US-A- 4 253 056
- US-A- 4 839 633
- ELECTRONIC ENGINEERING, Band 49, Nr. 589, März 1977, Seite 17, London, GB; R.BAYER: "Decrease/increase voltage protection system with ICS"
- ELEKTRONIK, Band 33, Nr. 17, August 1984, Seiten 51-55, München, DE; W.HARDERICH: "Erdschlussüberwachung an ferngespeisten Leitungsstrecken"

## Beschreibung

Die Erfindung betrifft eine Sromversorgungseinrichtung gemäß dem Oberbegriff des Patentanspruchs 1.

Bei optischen Nachrichtenübertragungssystemen sind parallel zu den die Nachrichtensignale übertragenden Glasfaserleitungen zwei metallische Leitungsadern vorgesehen, die eine von einer Stromversorgungseinrichtung erzeugte Gleichspannung an die Leitungsgeräte der Übertragungsstrecke, beispielsweise Verstärker, liefern (Fernspeisung). Dazu ist die erste Leitungsader mit dem gegenüber einem Massepotential positiven Pol der Gleichspannung und die zweite Leitungsader mit dem gegenüber dem Massepotential negativen Pol verbunden, wobei der Betrag des am positiven Pol vorhandenen Potentials dem Betrag des am negativen Pol auftretenden Potentials entspricht. Somit liegt zwischen den beiden Leitungsadern eine bezüglich des Massepotentials symmetrische Gleichspannung. Die an das Übertragungssystem angeschlossenen Leitungsgeräte sind jeweils geerdet. Wird beispielsweise durch Grabungsarbeiten eine Leitungsader beschädigt und kommt es dadurch zu einer Verbindung dieser Leitungsader mit dem Massepotential (einseitiger Erdschluß), so hat diese Unsymmetrie der Gleichspannung eine Störung bzw. einen Ausfall der von der Gleichspannung ferngespeisten Leitungsgeräte zur Folge. Eine Unsymmetrieüberwachungsschaltung soll diesen Betriebszustand überwachen.

Aus US-A-4 253 056 ist eine Stromversorgungseinrichtung mit Unsymmetrieüberwachungsschaltung bekannt, bei der zur Überwachung der Unsymmetrie vier Transistoren, zwei Dioden und ein Spannungsvergleicher verwendet werden. Die Widerstände bilden zwei Spannungsteiler, deren Mittenabgriffe auf verschiedenem Potential liegen. Die beiden Mittenabgriffe der Spannungsteiler sind über die zwei Dioden gekoppelt, wobei der Mittenabgriff der Reihenschaltung aus den Dioden auf Massepotential geschaltet ist und der Spannungsvergleicher mit den Spannungsteilermittenabgriffen verbunden ist.

Der Erfindung liegt die Aufgabe zugrunde, eine Stromversorgungseinrichtung der eingangs genannten Art anzugeben, die auf einfache Weise die Symmetrie der Gleichspannung bezüglich des Massepotentials zuverlässig überwacht.

Diese Aufgabe wird bei einer Stromversorgungseinrichtung der eingangs genannten Art durch die im kennzeichnenden Teil des Anspruchs 1 angegebenen Merkmale gelöst.

Durch den Vergleich der ersten positiven mit der zweiten negativen Teilspannung bzw. durch den Vergleich der zweiten positiven mit der ersten negativen Teilspannung wird die Symmetrie der Gleichspannung bezüglich des Massepotentials zuverlässig überwacht. Dabei wird die Ausgangsspannung der beiden Operationsverstärker bei Symmetrie jeweils zu Null, während beim Auftreten einer Unsymmetrie der Gleichspannung bezüglich des Massepotentials eine Störung signalisiert wird.

Bei einer Ausgestaltungsform ist jeweils ein Abgriff für eine positive und eine negative Teilspannung an den Vergleicher angeschlossen. Als Spannungsversorgung für die Vergleicher der Unsymmetrieüberwachungsschaltung dient dabei eine in der Stromversorgungseinrichtung ohnehin, beispielsweise für eine Regelschaltung, benötigte Gleichspannung. Dadurch, daß zum Betrieb der Unsymmetrieüberwachungsschaltung keine eigene separate und insbesondere bezüglich der Gleichspannung potentialfreie Versorgungsspannung benötigt wird, kann die Unsymmetrieüberwachungsschaltung auch bei bereits installierten Stromversorgungseinrichtungen einfach und kostengünstig nachgerüstet werden.

Bei einer Ausgestaltungsform sind die Bauteile der Spannungsteilerschaltungen als Widerstände ausgebildet, wodurch sich eine vom jeweiligen Wert der Gleichspannung abhängige Ansprechschwelle der Operationsverstärker ergibt.

Dadurch, daß die Bauteile zwischen den Abgriffen als Dioden ausgebildet sind, kann die Ansprechschwelle der Operationsverstärker konstant und damit unabhängig von dem jeweiligen Wert der Gleichspannung gemacht werden.

Weitere vorteilhafte Ausgestaltungsformen sind in den Unteransprüchen enthalten.

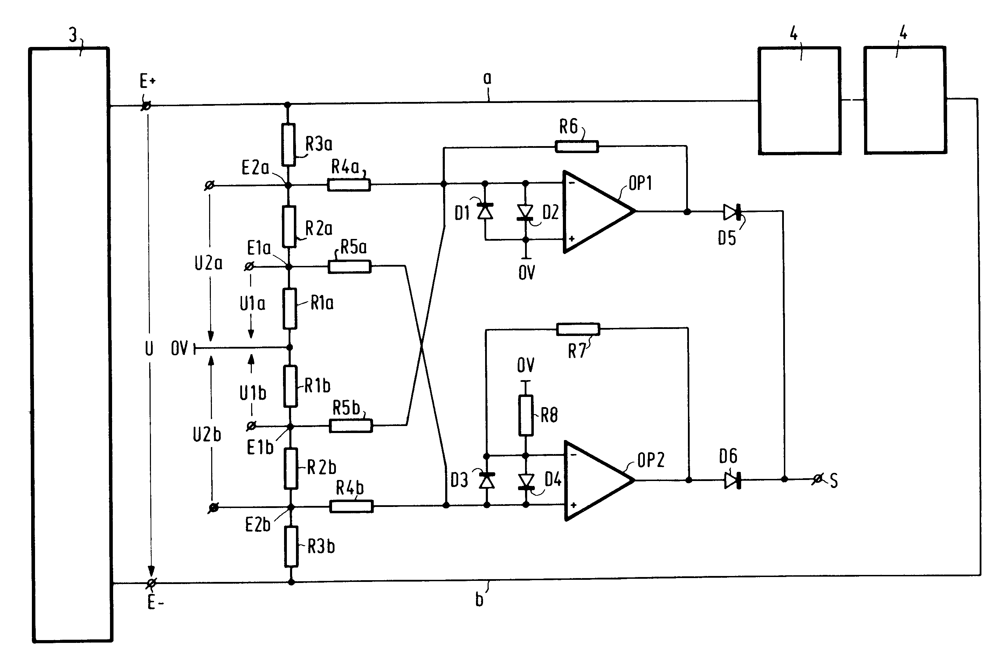

Im folgenden wird die Erfindung anhand des in der Figur dargestellten Ausführungsbeispiels näher erläutert.

Die Figur zeigt eine Stromversorgungseinrichtung mit Unsymmetrieüberwachungsschaltung.

Bei dem in der Figur dargestellten Ausführungsbeispiel liegt die Unsymmetrieüberwachungsschaltung zwischen einem positiven Pol E+ und einem negativen Pol E- einer bezüglich eines Massepotentials 0V symmetrischen Gleichspannung U. Die Gleichspannung U wird aus einer Stromversorgungseinrichtung 3 geliefert und speist über zwei Leitungsadern a, b zwei Leitungsgeräte 4 beispielsweise eines optischen Nachrichtenübertragungssystems fern. Durch die gestrichelt eingezeichnete Linie zwischen den zwei Leitungsgeräten 4 ist angedeutet, daß noch weitere Leitungsgeräte einschaltbar sind. Die erste Leitungsader a ist an den positiven Pol E+ und die zweite Leitungsader b an den negativen Pol E- der Gleichspannung U angeschlossen. Zwischen den zwei Leitungsadern a, b und dem Massepotential 0V liegt jeweils eine Reihenschaltung aus sechs jeweils paarweise gleichen Widerständen R1a, R2a, R3a, R1b, R2b, R3b, an deren Abgriffen E1a, E2a, E1b, E2b jeweils zwei auf Massepotential bezogene positive U1a, U2a und negative U1b, U2b Teilspannungen abgreifbar sind. Die Widerstände R1a, R2a, R3a, R1b, R2b, R3b sind dabei so dimensioniert, daß der Wert des Widerstandes R1a dem Wert des Widerstands R1b, der Wert des Widerstands R2a dem Wert des Widerstands R2b und der Wert des Widerstands R3a dem Wert des Widerstands R3b entspricht. Somit liegt zwischen dem Abgriff E1a und dem Massepotential 0V die erste positive Teilspannung U1a und an der Reihenschaltung aus den Widerständen R1a, R2a zwischen dem Abgriff E2a und dem Massepotential 0V die zweite positive Teilspannung U2a. Entsprechend liegt am Widerstand R1b zwischen dem Abgriff E1b und dem Massepotential 0V eine erste negative Teilspannung U1b, und an der Reihenschaltung der Widerstände R1b, R2b zwischen dem Abgriff E2b und dem Massepotenial 0V eine zweite negative Teilspannung U2b. Der gemeinsame Abgriff E2a der Widerstände R2a, R3a ist über einen Widerstand R4a mit dem invertierenden Eingang eines ersten Operationsverstärkers OP1 verbunden, dessen nichtinvertierender Eingang auf Massepotential 0V geschaltet ist. Weiterhin ist der invertierende Eingang des ersten Operationsverstärkers OP1 über einen Widerstand R5b mit dem gemeinsamen Abgriff E1b der Widerstände R1b, R2b verbunden. Entsprechend ist der gemeinsame Abgriff E2b der Widerstände R2b, R3b über einen Widerstand R4b mit dem nichtinvertierenden Eingang eines zweiten Operationsverstärkers OP2 verbunden, dessen invertierender Eingang über einen Widerstand R8 auf Massepotential 0V geschaltet ist. Der gemeinsame Abgriff E1a der Widerstände R1a, R2a ist über einen Widerstand R5a ebenfalls an den nichtinvertierenden Eingang des zweiten Operationsverstärkers OP2 angeschlossen. Die beiden Operationsverstärker OP1, OP2 sind jeweils über einen Widerstand R6, R7 rückgekoppelt. Zwischen dem invertierenden und dem nichtinvertierenden Eingang der Operationsverstärker OP1, OP2 sind jeweils antiparallel geschaltete Dioden D1, D2, D3, D4 angeordnet. Die Ausgänge der Operationsverstärker OP1, OP2 sind jeweils über Dioden D5, D6 mit einem Signalisierungsanschluß S verbunden. Die Operationsverstärker OP1, OP2 werden mit einer auf Massepotential bezogenen Hilfsspannung betrieben, die aus der Stromversorgungseinrichtung 3 zuführbar ist und ohnehin für eine dort vorgesehene Regelschaltung benötigt wird.

Im Normalbetrieb, das heißt wenn keine Störung der Fernspeisung der Gleichspannung U über die Leitungsadern 1, 2 erfolgt, liegt die Gleichspannung U symmetrisch zum Massepotential 0V zwischen der Leitungsader a und der Leitungsader b, das heißt, der Betrag der ersten positiven Teilspannung U1a ist gleich dem Betrag der ersten negativen Teilspannung U1b und der Betrag der zweiten positiven Teilspannung U2a gleich dem Betrag der zweiten negativen Teilspannung U2b. Damit ergibt sich am Ausgang des ersten Operationsverstärkers OP1 eine Spannung, die sich aus dem Produkt des Rückkopplungswiderstandes R6 mit der Summe des Quotienten der zweiten positiven Teilspannung U2a und des Widerstands R4a und dem Quotienten der ersten negativen Teilspannung U1b und dem Widerstand R5b ergibt. Die Widerstände R4a, R5b sind dabei so dimensioniert, daß U2a/U1b = R4a/R5b ist. Dadurch wird der Betrag U2a/R4a gleich dem Betrag U1b/R5b und die Ausgangsspannung des ersten Operationsverstärkers OP1 zu Null, das heißt, es erfolgt keine Signalisierung einer Störung über den Signalisierungsanschluß S. Die Widerstände R4b, R5a sind entsprechend dimensioniert, das heißt, der Wert des Widerstandes R4b entspricht dem Wert des Widerstandes R4a und der Wert des Widerstandes R5a dem Wert des Widerstandes R5b. Damit wird im Normalbetrieb auch die Ausgangsspannung des zweiten Operationsverstärkers OP2 zu Null.

Kommt es jedoch infolge einer beispielsweise durch Grabungsarbeiten verursachten Störung zu einer Unsymmetrie der Gleichspannung U bezüglich des Massepotentials 0V und damit auch zur Unsymmetrie der positiven und negativen Teilspannungen, so ist der Betrag des Quotienten U2a/R4b nicht mehr gleich dem Betrag des Quotienten U1b/R5b. Damit nimmt auch die Ausgangsspannung des ersten Operationsverstärkers OP1 einen von Null verschiedenen Wert an, der über den Signalisierungsanschluß S beispielsweise eine Leuchtdiode zum Ansprechen bringt und so die Störung signalisiert. Entsprechend wird über den zweiten Operationsverstärker OP2 der Signalisierungsanschluß S angesteuert.

Über die Widerstände R1a, R2a bzw. R1b, R2b wird die Ansprechschwelle der Operationsverstärker OP1, OP2 festgelegt. Dabei ist bei dem in der Figur dargestellten Ausführungsbeispiel die Ansprechschwelle proportional zur Gleichspannung U gewählt, die bei einer praktisch ausgeführten Schaltungsanordnung beispielsweise Werte zwischen 30 und 1 200 Volt annehmen kann. Bei einer weiteren in der Figur nicht dargestellten Ausführungsform sind die Widerstände R2a, R2b beispielsweise durch Zenerdioden ersetzt. Damit kann die Ansprechschwelle konstant, d.h. unabhängig von dem aktuellen Wert der Gleichspannung U, gewählt werden. Anstelle der Operationsverstärker OP1, OP2 können auch beispielsweise Komparatoren verwendet werden, deren Auswertung mit Hilfe eines Mikroprozessors erfolgen kann.

## Patentansprüche

1. Stromversorgungseinrichtung mit Unsymmetrieüberwachungsschaltung für eine zwischen zwei Leitungsadern (a, b) übertragene bezüglich eines Massepotentials (0V) symmetrische Gleichspannung (U), wobei zwischen den zwei Leitungsadern (a, b) eine aus jeweils paarweise gleichen Bauteilen (R1a...R5a, R1b...R5b) mit jeweils gleichen widerstandswerten bestehende Spannungsteilerschaltung angeordnet ist, deren Mittenabgriff mit dem Massepotential (OV) verbunden ist und an deren weiteren Abgriffen (E1a, E1b, E2a, E2b) auf Massepotential (OV) bezogene positive (U1a, U2a) und negative (U1b, U2b) Teilspannungen abgreifbar sind, wobei die Unsymmetrieüberwachungsschaltung einen ersten Vergleicher (OP1) zum Vergleich einer ersten positiven (U1a) mit einer zweiten negativen (U2b) Teilspannung aufweist,
dadurch gekennzeichnet,
daß die Unsymmetrieüberwachungsschaltung einen zweiten Vergleicher (OP2) zum Vergleich der zweiten positiven (U2a) mit einer ersten negativen (U1b) Teilspannung aufweist und daß beide vergleicher als Operationsverstärker (OP1, OP2) ausgebildet sind, wobei der invertierende Eingang des ersten Operationsverstärkers (OP1) über jeweils ein Bauteil (R4a, R5b) der Spannungsteilerschaltung an die Abgriffe (E2a) für die zweite positive (U2a) und die erste negative (U1b) Teilspannung, der nichtinvertierende Eingang des zweiten Operationsverstärkers (OP2) über jeweils ein Bauteil (R5a, R4b) an die Abgriffe (E1a, E2b) für die erste positive (U1a) und die zweite negative (U2b) Teilspannung angeschlossen ist und der nichtinvertierende Eingang des ersten (OP1) und der invertierende Eingang des zweiten Operationsverstärkers (OP2) auf Massepotential (OV) liegen.

2. Stromversorgungseinrichtung nach Anspruch 1,
dadurch gekennzeichnet,
daß zwischen den Leitungsadern (a, b) eine Reihenschaltung aus jeweils paarweise gleichen Bauteilen (R1a...R3a, R1b...R3b) angeordnet ist.

3. Stromversorgungseinrichtung nach einem der Ansprüche 1 oder 2,
dadurch gekennzeichnet,
daß die Bauteile (R1a...R5a, R1b...R5b) der Spannungsteilerschaltung als ohmsche Widerstände ausgebildet sind.

4. Stromversorgungseinrichtung nach einem der Ansprüche 1 bis 3,
dadurch gekennzeichnet,
daß die Ausgänge der Operationsverstärker (OP1, OP2) miteinander verbunden sind, wobei der gemeinsame Verbindungspunkt als Signalisierungsanschluß (S) ausgebildet ist.

5. Stromversorgungseinrichtung nach einem der Ansprüche 1 bis 4,
dadurch gekennzeichnet,
daß die Operationsverstärker (OP1, OP2) jeweils über einen Widerstand (R6, R7) rückgekoppelt sind.

6. Stromversorgungseinrichtung nach einem der Ansprüche 1 bis 5,
dadurch gekennzeichnet,
daß jeweils zwischen dem invertierenden und dem nichtinvertierenden Eingang der Operationsverstärker (OP1, OP2) Dioden (D1, D2, D3, D4) antiparallel geschaltet sind.

## Claims

1. A power supply device with a non-symmetry monitoring circuit for a direct voltage (U) which is transmitted between two line conductors (a, b) and is symmetrical relative to ground potential (0V), between the two line conductors (a, b) there being arranged a voltage divider circuit consisting of pair-wise identical components (R1a...R5a, R1b...R5b) with each time the same resistance values, the centre tap thereof being connected to ground potential (0V) whereas from the further taps thereof (E1a, E1b, E2a, E2b) there can be derived sub-voltages which are positive (U1a, U2a) and negative (U1b, U2b) relative to ground potential (0V), the non-symmetry monitoring circuit comprising a first comparator (OP1) for comparing a first positive sub-voltage (U1a) with a second negative sub-voltage (U2b),
characterized in that
the non-symmetry monitoring circuit comprises a second comparator (OP2) for comparing a the second positive sub-voltage (U2a) with a first negative sub-voltage (U1b) and that both comparators are constructed as operational amplifiers (OP1, OP2), the inverting input of the first operational amplifier (OP1) being connected, via a respective component (R4a, R5b) of the voltage divider circuit, to the taps (E2a) for the second positive sub-voltage (U2a) and the first negative sub-voltage (U1b), the non-inverting input of the second operational amplifier (OP2) being connected, via a respective component (R5a, R4b), to the taps (E1a, E2b) for the first positive sub-voltage (U1a) and the second negative sub-voltage (U2b), the non-inverting input of the first operational amplifier (OP1) and the inverting input of the second operational amplifier (OP2) being connected to ground potential (0V).

2. A power supply device as claimed in Claim 1,
characterized in that
between the line conductors (a, b) there is arranged a series connection of pair-wise identical components (r1a...R3a, R1b...R3b).

3. A power supply device as claimed in one of the Claims 1 or 2,
characterized in that
the components (R1a...R5a, R1b...R5b) of the voltage divider circuit are constructed as ohmic resistors.

4. A power supply device as claimed in any one of the Claims 1 to 3,
characterized in that
the outputs of the operational amplifiers (OP1, OP2) are interconnected, the common junction forming a signalling terminal (S).

5. A power supply device as claimed in any one of the Claims 1 to 4,
characterized in that
the operational amplifiers (OP1, OP2) are fed back via a respective resistor (R6, R7).

6. A power supply device as claimed in any one of the Claims 1 to 5,
characterized in that
respective antiparallel-connected diodes (D1, D2, D3, D4) are arranged between the inverting and the non-inverting input of the operational amplifiers (OP1, OP2).

## Revendications

1. Source d'alimentation avec circuit détecteur de dissymétrie pour une tension continue (U) symétrique par rapport à un potentiel de masse (0V), transmise entre deux conducteurs (a, b), un circuit diviseur de tension, constitué de modules égaux deux à deux (R1a ... R5a, R1b ... R5b) ayant respectivement les mêmes valeurs de résistance, étant disposé entre les deux conducteurs (a, b) et dont les prises centrales sont reliées au potentiel de masse (0V) et aux autres prises (E1a, E1b, E2a, E2b) desquels on peut prélever des tensions (U1a, U2a) positives par rapport au potentiel de masse (0V) et des tensions (U1b, U2b) négatives par rapport au potentiel de masse (0V), le circuit détecteur de dissymétrie possédant un premier comparateur (OP1) pour la comparaison d'une première tension partielle positive (U1a) avec une deuxième tension partielle négative (U2b), caractérisée en ce que le circuit détecteur de dissymétrie possède un deuxième comparateur (OP2) pour la comparaison d'une deuxième tension partielle positive (U2a) avec une première tension partielle négative (U1b) et en ce que les deux comparateurs sont constitués sous forme d'amplificateurs opérationnels (OP1, OP2), l'entrée inversée du premier amplificateur opérationnel (OP1) étant connectée via respectivement un module constructif (R4a, R5b) du circuit diviseur de tension à la prise (E2a) pour la deuxième tension partielle positive (U2a) et pour la première tension partielle négative (U1b), l'entrée non inversée du deuxième amplificateur opérationnel (OP2) étant connectée via, respectivement, un module constructif (R5a, R4b) aux prises (E1a, E2b) pour la première tension partielle positive (U1a) et pour la deuxième tension partielle négative (U2b) et l'entrée non inversée du premier amplificateur opérationnel (OP1) et l'entrée inversée du deuxième amplificateur opérationnel (OP2) étant connectées au potentiel de masse (0V).

2. Source d'alimentation suivant la revendication 1, caractérisée en ce qu'un circuit série constitué de modules égaux respectivement deux à deux (R1a ... R3a, R1b ... R3b) est disposé entre les conducteurs a, b).

3. Source d'alimentation suivant l'une quelconque des revendications 1 ou 2, caractérisée en ce que les modules (R1a ... R5a, R1b ... R5b) du circuit diviseur de tension sont constitués de résistances ohmiques.

4. Source d'alimentation suivant l'une quelconque des revendications 1 à 3, caractérisée en ce que les sorties des amplificateurs opérationnels (OP1, OP2) sont reliées entre elles, le point commun de liaison servant de raccordement de signalisation (S).

5. Source d'alimentation suivant l'une quelconque des revendications 1 à 4, caractérisée en ce que les amplificateurs opérationnels (OP1, OP2) sont branchés en rétroaction respectivement via une résistance (R6, R7).

6. Source d'alimentation suivant l'une quelconque des revendications 1 à 5, caractérisée en ce que l'entrée inversée et l'entrée non inversée des amplificateurs opérationnels (OP1, OP2) sont branchées de manière antiparallèle à l'aide de diodes (D1, D2, D3, D4).
